# EUROPEAN PATENT APPLICATION

(11) **EP 0 693 572 A2**
(43) Date of publication of application: **24.01.1996**
(21) Application number: 95304972.3
(22) Date of filing: 17.07.1995
(51) Int. Cl.: C23C 14/48, C23C 30/00, B21D 28/34, B21D 37/01

(54) **Glass cutting wheel**

(30) Priority: 22.07.1994 US 279375
(71) Applicant: FORD MOTOR COMPANY, Dearborn, MI 48126 (US)
(72) Inventor: Benoit, Robert Eugene, Livonia, Michigan 48154 (US); Platts, Dennis R., Livonia, Michigan 48152 (US); Allor, Richard Lawrence, Livonia, Michigan 48152 (US)
(74) Representative: Messulam, Alec Moses

(57) **Abstract**

A disposable glass cutter wheel (12) assembly comprising a disc-shaped cutter wheel of nitrogen ion-implanted cobalt-cemented tungsten carbide and a cylindrical axle (18) passing through a centre hole (16) in the cutter wheel (12), the axle (18) also being of nitrogen ion-implanted cobalt-cemented tungsten carbide.

## Description

The present invention relates to an improved disposable cutting wheel for scoring flat glass along a break line and to cutting wheel assemblies and methods of using them.

High energy ion implantation is known to be a useful technique for hardening the working surface of various cemented carbide cutting tools. A wide variety of carbide materials are known and used in a variety of matrix materials. Aluminium/silicon alloys are implanted with nitrogen or carbon to form silicon nitride and silicon carbide particles in a matrix of aluminium nitride and aluminium carbide in U.S Patent 5,272,015 to Hamdi et al. Similarly, U.S. Patent 4,640,169 to Fromson et al is directed to resharpenable cemented carbide cutting tools, particularly punches and dies for use in perforating metal or other material, comprising cemented carbide having a wear-resistant layer formed by implantation of high energy ion species at only one of two surfaces which join to form a cutting edge. A resharpenable cobalt-cemented tungsten carbide punch and die is discussed in the Example of the Fromson et al patent, having faces of the punch and die segments implanted with nitrogen ions for working low carbon steel sheet and silicon steel sheet without lubrication. Various other carbide and matrix materials implanted with selected species have been suggested for particular applications.

The flat glass manufacturing industry employs cutter wheels for scoring glass along a break line. This is done both on float lines during initial glass production and in glass product fabrication operations. The wheels are small diameter, typically being .225 to .227 or .165 to .167 inch diameter with a thickness of about 0.42 to 0.43 inch. The wheels are disposable and a typical glass float line may use and discard tens of thousands of cutter wheels per year. It would be highly advantageous to use cutter wheels which are more resistant to wear, that is, cutter wheels having a longer service life. Because of the large number of glass cutter wheels used and their discardable nature, any such improvement in cutter wheel durability must be achieved at minimal added manufacturing cost. It is an object of the present invention to provide improved glass cutter wheels and cutter wheel assemblies. Additional objects of the invention will become apparent from the following disclosure.

In accordance with a first aspect, a cutter wheel is provided for scoring flat glass along an intended break line, the cutter wheel having a cutting surface at its outer circumferential periphery formed of cobalt-cemented tungsten carbide hardened by nitrogen ion implantation. In view of the typically small size of glass cutter wheels, the improved cutter wheels of the invention preferably are formed entirely of such nitrogen ion-implanted cobalt-cemented tungsten carbide. The invention is commercially significant most particularly because it is sufficiently economical to provide cost benefits over existing cutter wheels. That is, nitrogen is considerably less expensive than many other implantation species which have been used or suggested for other applications. Cobalt-cemented tungsten carbide cutter wheels are commercially available and are advantageously susceptible to nitrogen ion implantation. This is critical in the glass manufacture and fabrication industries in view of the large numbers of cutter wheels used and discarded annually in a typical glass production or fabrication operation, as discussed above.

In accordance with another aspect of the invention, a method is provided for cutting flat glass, comprising rolling over its surface a glass cutter wheel having a nitrogen ion-implanted cobalt-cemented tungsten carbide working surface at its outer circumferential periphery and, more preferably, being formed entirely of such material. As stated above, it is found that large numbers of commercially available cobalt-cemented tungsten carbide cutter wheels can be hardened by nitrogen ion implantation sufficiently economically even for the cost-critical application of disposable glass cutter wheels. In this regard, the economic advantage lies not only in the extended working life of the cutter wheel itself, but also in the reduced amount of glass normally lost in cutter wheel changeover. That is, although still disposable, the glass cutter wheel of the invention must be replaced less often, with consequent reduction in the loss of glass during the changeover. These and additional features and advantages of the invention will be better understood from the following detailed description of certain preferred embodiments.

The invention will now be described further, by way of example, with reference to the accompanying drawings, in which:

Fig. 1 is an exploded perspective view of a cutter wheel assembly in accordance with a preferred embodiment.

Fig. 2 is a perspective view of the wheel assembly of Fig. 1 shown in its assembled form.

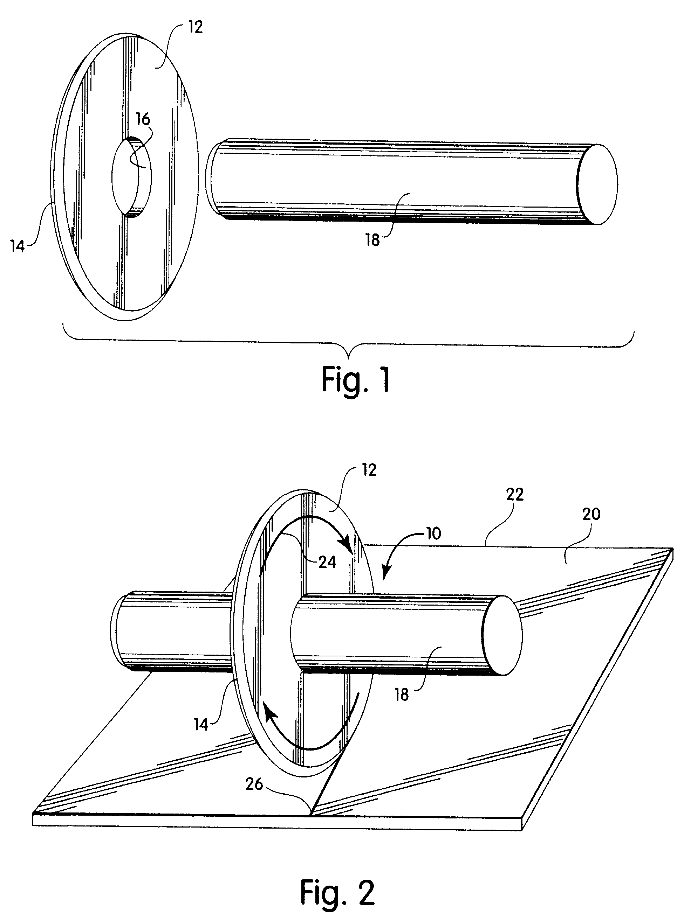

It should be recognised that the drawings of the invention in Figs. 1 and 2 are schematic in nature, not necessarily being to scale.

As disclosed above, the present invention provides a disposable cobalt-cemented tungsten carbide glass cutter wheel hardened by nitrogen ion implantation. The nitrogen ion implantation gives the cutter wheel an extended working life. In this regard, those who are skilled in this area of technology will recognise the significant advantage provided by a cutter wheel having an extended life and yet retaining proper glass cutting or scoring characteristics, since a proper glass cutting operation involves a complex interaction between the wheel and the glass. Properly using a cutter wheel of correct technical characteristics produces an almost invisible hairline scoring with almost no flaking or fuzzing and no frayed or chipped edges. Rather, a proper cutter wheel operation produces subsurface defects in the nature of a vent, that produces an easy, clean break of the flat glass sheet. Preferred embodiment of the nitrogen ion-implanted cobalt-cemented tungsten carbide cutter wheels are found to be particularly well-suited for cutting soda-lime-silica flat glass.

Suitable cobalt-cemented tungsten carbide cutter wheels are commercially available. For example, from the Paul A. MacInnes Tool Corp., Rochester, NY. Preferably, the cutter wheel has an overall outside diameter of .225 inch to .227 inch or from .165 inch to .167 inch, with a thickness of .042 to .043 inch. The wheels are rotatably mounted on an axle and are provided, therefore, with an axle hole having an inside diameter of .005 to .006 inch. The cutting edge at the outer circumferential periphery of the cutter wheel is bevelled at an included angle of 105° to 154° ±30" depending on the type of glass to be cut. For soda-lime-silica window and plate glass, the cutter wheel preferably has an included angle of approximately 125° for light rolling pressure on the glass or about 134° for average rolling pressure on the glass. Preferably the cobalt-cemented tungsten carbide to be hardened by nitrogen ion implantation consists essentially of tungsten carbide of less than 1 micron grain size, such as .7 to 1.0 micron, having Rockwell A 93 hardness and density of 14 to 16 g/cm³, more preferably 14.9g/cm³, in 5% to 7% by weight cobalt matrix, more preferably 6% cobalt.

The nitrogen ion-implantation can be accomplished in accordance with various techniques known to those who are skilled in this area of technology. Preferably the cutter wheels are nitrogen ion-implanted at an ion beam energy of 90-180 keV, preferably, 90-120 keV, most preferably 90-105 keV, to a dose of 1.0 x 10¹⁷ to 5.0 x 10¹⁷ ions/cm more preferably to a dose of 2.0 to 2.4 x 10¹⁷ ions/cm, most preferably about 2.16 x 10¹⁷ ions/cm. It is found that nitrogen ion implantation at these dose levels can be accomplished at a considerably lower cost than, for example, boron ion implantation, and with better hardening results. The implantation preferably takes place at a temperature between 260° and 400°C. More specifically, a multitude of cobalt-cemented tungsten carbide cutter wheels are heated to about 400°C then loaded into a nitrogen ion implantation unit on spindles, and then nitrogen ion implanted for a time sufficient to achieve the aforesaid dose level, during which time the temperature will fall to about 260°C. Without wishing to be bound by theory, it is presently believed that the nitrogen ion-implantation occurs to a depth of approximately 535 Å

In accordance with a particularly preferred embodiment of the invention, the nitrogen ion-implanted cobalt-cemented tungsten carbide cutter wheels are used in a cutter wheel assembly in which they are rotatably mounted on an axle. In use, the longitudinal axis of the axle would be substantially parallel to the plane of the glass surface on which the cutter wheel is acting, such that the cutter wheel is in a plane substantially perpendicular to the plane of the glass surface, with the circumferential outer periphery of the cutter wheel in contact with the glass surface. Referring now to the appended drawings, Figs. 1 and 2 illustrate a disposable cutter wheel assembly 10 comprising a nitrogen ion-implanted cobalt-cemented tungsten carbide glass cutter wheel at 12 having a cutting edge 14 extending circumferentially about its outer periphery. The cutter wheel has a centrally located axle hole 16 for receiving axle 18. Axle 18 and cutter wheel 12 each consists essentially of a single unitary body of cobalt-cemented tungsten carbide which has been nitrogen ion-implanted (preferably prior to assembling one to the other) for improved hardness. In Fig. 2 the cutter wheel assembly 10 is seen to be in contact with upper surface 20 of glass sheet 22, having rotated in the direction of arrow 24 to form score line 26 on the glass surface 22 along an intended break line.

## Claims

1. A disposable cutter wheel for scoring flat glass along a break line, the cutter wheel (12) having a cutter surface (14) at its outer circumferential periphery formed of cobalt-cemented tungsten carbide hardened by nitrogen ion implantation.

2. A disposable cutter wheel for scoring flat glass as claimed in claim 1, wherein the cutter wheel is 0.42 to 0.58 cms (.165 to .227 inch) in diameter, and 1.0668 to 1.0922 cms (.42 to .43 inch) substantially uniform thickness, and is formed entirely of cobalt-cemented tungsten carbide hardened by a nitrogen ion implantation dose of 1.0 x 10¹⁷ to 5.0 x 10¹⁷ ions/cm at a temperature between 260°C and 400°C.

3. A disposable cutter wheel for scoring flat glass as claimed in claim 2, wherein the cobalt-cemented tungsten carbide cutting surface consists essentially of tungsten carbide of less than 1 micron grain size in 5% to 7% by weight cobalt.

4. A disposable glass cutter wheel assembly comprising a disc-shaped cutter wheel of nitrogen ion-implanted cobalt-cemented tungsten carbide and a cylindrical axle passing through a centre hole in the cutter wheel, the axle also being of nitrogen ion-implanted cobalt-cemented tungsten carbide.

5. A method of cutting flat glass comprising rolling over its surface under pressure a disposable glass cutter wheel assembly having a cutting surface at its outer circumferential periphery formed of cobalt-cemented tungsten carbide hardened by nitrogen ion-implantation.

6. A method as claimed in claim 5, wherein the cutter wheel assembly further comprises a cylindrical axle passing through a centre hole in the cutting wheel, the axle also being of nitrogen ion-implanted cobalt-cemented tungsten carbide.
